# EUROPÄISCHE PATENTSCHRIFT

(11) **EP 1 088 378 B1**
(45) Veröffentlichungstag und Bekanntmachung des Hinweises auf die Patenterteilung: **25.08.2004**
(21) Anmeldenummer: 99936333.6
(22) Anmeldetag: 27.05.1999
(51) Int. Cl.: H01S 5/022

(54) **GEHÄUSEANORDNUNG FÜR LASERMODUL**
HOUSING ARRANGEMENT FOR A LASER MODULE
ENSEMBLE BOITIER POUR MODULE LASER

(30) Priorität: 27.05.1998 DE 19823691
(43) Veröffentlichungstag der Anmeldung: 04.04.2001
(73) Patentinhaber: Infineon Technologies AG, 81669 München (DE)
(72) Erfinder: ALTHAUS, Hans-Ludwig, D-93138 Lappersdorf (DE); AURACHER, Franz, D-82065 Baierbrunn (DE)
(74) Vertreter: Epping, Hermann, Fischer
(86) Internationale Anmeldenummer: PCT/DE1999/001562
(87) Internationale Veröffentlichungsnummer: WO 1999/062150

(56) Entgegenhaltungen:
- EP-A- 0 375 231
- WO-A-92/13369
- DE-A- 4 106 720
- DE-A- 4 112 471
- DE-C- 19 704 502
- US-A- 5 011 256
- US-A- 5 412 748
- PATENT ABSTRACTS OF JAPAN vol. 1996, no. 10, 31. Oktober 1996 (1996-10-31) & JP 08 152541 A (NEC CORP), 11. Juni 1996 (1996-06-11)
- PATENT ABSTRACTS OF JAPAN vol. 016, no. 142 (E-1187), 9. April 1992 (1992-04-09) & JP 04 000782 A (NEC CORP), 6. Januar 1992 (1992-01-06)
- PATENT ABSTRACTS OF JAPAN vol. 011, no. 343 (E-555), 10. November 1987 (1987-11-10) & JP 62 124780 A (HITACHI LTD), 6. Juni 1987 (1987-06-06)

## Beschreibung

Die Erfindung betrifft eine Gehäuseanordnung für ein Lasermodul mit einem hermetisch dichten Modulgehäuse, das das Lasermodul enthält und das mindestens einen laserlichtdurchlässigen Austrittswandabschnitt aufweist, mit einer Trägerplatte, die entweder den Boden des Modulgehäuses ausbildet oder einen Gehäuseboden des Modulgehäuses trägt und mit einer Einrichtung zur Ankopplung eines Lichtleiters.

Ein bekanntes Gehäuse für gekühlte Lasermodule (sogenanntes Butterfly-Gehäuse) besteht aus einer metallischen Grundplatte, auf der ein Kühlelement mit einem darauf angeordneten Lasermodul sowie gegebenenfalls weitere optische Elemente angebracht sind. Das Gehäuse ist mit einem Metalldeckel durch Schweißen oder Löten hermetisch dicht verschlossen. Die Ankopplung der optischen Faser erfolgt über einen im Bereich eines Gehäusefensters an dem Gehäuse angebrachten Faserflansch. Mit einem solchen Gehäuse lassen sich Datenraten von über 2,5 Gbit/s erzielen. Wegen der Forderung nach hermetischer Dichtigkeit müssen jedoch hohe Anforderungen an das Gehäuse als solches, seine elektrischen Durchführungen und die Abdichtung des optischen Fensters gestellt werden. Ferner können in dem Gehäuse nur nicht-ausgasende Bauteile und Materialien verwendet werden. Aus diesen Gründen sind mit derartigen Gehäusen versehene optoelektronische Bauteile verhältnismäßig teuer.

Aus der US 5,566,265 ist ein sogenanntes TO (Transistor Outline)-Gehäuse bekannt, das für den Betrieb von ungekühlten Lasermodulen verwendet wird. Dieses Gehäuse ist kostengünstig herstellbar. Nachteilig ist jedoch, daß es aufgrund der fehlenden Möglichkeit einer Temperaturstabilisierung nicht für wellenlängenstabile Lasermodule einsetzbar ist, und daß es aufgrund des Vorhandenseins von bodenplattenseitigen HF-Durchführungen in Form von eingeglasten Pins, welche bei hohen Frequenzen eine HF-Einkopplung behindern, nur bedingt für Datenraten über 2,5 Gbit/s geeignet ist.

Der Erfindung, wie sie in den Ansprüchen 1 und 2 definiert ist, liegt die Aufgabe zugrunde, eine Gehäuseanordnung für ein Lasermodul zu schaffen, die kostengünstig herstellbar ist, eine hohe Datenrate ermöglicht und insbesondere auch für wellenlängenstabile gekühlte Lasermodule geeignet ist.

Zur Lösung der genannten Aufgabe ist vorgesehen, daß die Trägerplatte einen aus einem dielektrischen Material bestehenden HF-Leiterbahnträger umfaßt, und daß zur elektrischen HF-Kontaktierung des Lasermoduls eine an dem HF-Leiterbahnträger geführte HF-Leiterbahnstrecke vorgesehen ist.

Durch die an oder in der Trägerplatte verlaufende HF-Leiterbahnstrecke wird erreicht, daß das Modulgehäuse die gewünschten gute HF-Eigenschaften aufweist. Gleichzeitig wird durch die erfindungsgemäße Anordnung der Trägerplatte - indem sie den Gehäuseboden des Modulgehäuses trägt oder sogar selber den Boden des Modulgehäuses ausbildet - gewährleistet, daß stets eine gute thermische Ankopplung der Trägerplatte an das Lasermodul erzielbar ist. Dies ermöglicht einen temperaturstabilen Betrieb des Lasermoduls und damit die Schaffung von wellenlängenstabilen Lasermodulen, wie sie für optische übertragungssysteme mit Wellenlängenmultiplex-(WDM: Wavelength Division Multiplexing)Übertragung benötigt werden.

Ein weiterer wesentlicher Vorteil der Erfindung besteht darin, daß aus mehreren Gründen ein kostengünstiger Gesamtaufbau ermöglicht wird. Zunächst kann das Modulgehäuse als solches sehr kostensparend hergestellt werden. Wenn die Trägerplatte den Boden des Gehäuses bildet, kann dieses in einfacher Weise aus einer auf die Trägerplatte hermetisch dicht aufgesetzten Kappe aufgebaut sein. Im anderen Fall (d.h. wenn die Trägerplatte den Gehäuseboden trägt) können bereits bestehende, kostengünstige TO-Gehäuse nach Kürzung ihrer Durchführungspins und Montage auf die erfindungsgemäße Trägerplatte in Art eines SMDs (SMD: Surface Mounted Device) zum Aufbau der erfindungsgemäßen Gehäuseanordnung eingesetzt werden. Dadurch werden die bekannten Vorzüge von in SMD-Bauweise hergestellten Schaltungsanordnungen erzielt. Alle weiteren ggf. vorgesehenen optischen Bauelemente, die außerhalb des Modulgehäuses angeordnet sind, müssen nicht den Anforderungen eines hermetisch dichten Aufbaus genügen, d.h. für sie können kostengünstige nicht-epoxidharzfreie Ausführungen gewählt werden. Somit schafft die Erfindung ein funktionell selbständiges, aufbaumäßig kompakt auslegbares und hermetisch dichtes Modulgehäuse, das eine "Kerneinheit" der erfindungsgemäßen Gehäuseanordnung bildet und dadurch für den Aufbau der erfindungsgemäßen Gehäuseanordnung ein hohes Maß an Modularität bzw. Gestaltungsvariabilität ermöglicht.

Beispielsweise kann die Ankopplung eines Lichtleiters vollständig getrennt von dem Modulgehäuse entweder an einem "ausgelagerten" optischen Bauteil oder einem äußeren Gehäuse erfolgen. Zur Ankopplung können bereits komplett gefertigte und getestete Ankoppeleinrichtungen verwendet werden, wodurch Ausbeuteprobleme bei der Endmontage deutlich verringert werden können.

Vorzugsweise ist die HF-Leiterbahnstrecke als Koplanarleitung oder Mikrostreifenleitung ausgeführt und weist einen Wellenwiderstand im Bereich von 25 Ω bis 50 Ω auf.

Nach einer bevorzugten Ausführungsvariante der Erfindung ist die den Boden des Modulgehäuses ausbildende Trägerplatte allein von dem aus dem dielektrischen Material bestehenden HF-Leiterbahnträger gebildet. Auf einer solchen Trägerplatte können neben der HF-Leiterbahnstrecke ferner Kontaktpads, weitere Leiterbahnen und gegebenenfalls auch weitere Bauelemente wie Dünnschichtwiderstände, integrierte Hybridverstärker usw. angeordnet sein. Eine aus einem gut wärmeleitenden Material wie Al₂O₃, BeO oder AlN bestehende Trägerplatte ist bevorzugt, weil eine solche eine gute Wärmeleitfähigkeit zur Abführung von Verlustwärme des Lasermoduls aufweist.

Eine alternative, ebenfalls bevorzugte Ausführungsvariante der Erfindung kennzeichnet sich dadurch, daß die den Boden des Modulgehäuses ausbildende Trägerplatte aus dem HF-Leiterbahnträger und einer über dem HF-Leiterbahnträger angeordneten, insbesondere aus Cu, einer Cu/W-Legierung oder Kovar bestehenden Metallschicht aufgebaut ist. In diesem Fall wird die von dem Lasermodul erzeugte Verlustwärme in effizienter Weise über die oberflächenseitig angeordnete Metallschicht verteilt und abgeführt. Im Falle einer Kühlung verbessert die Metallschicht die thermische Ankopplung des Lasermoduls an ein Kühlelement.

Ferner kann der HF-Leiterbahnträger auch als Mehrlagenplatine ausgeführt sein. In diesem Fall werden überkreuzungen von in unterschiedlichen Lagen verlaufenden Leiterbahnen ermöglicht, und die Leiterbahnen können bei Vorhandensein eines oberflächenseitig angeordneten Dichtring problemlos unter diesem hindurch geführt werden.

Wenn als Modulgehäuse wie bereits angesprochen ein TO-Gehäuse mit eigenem Gehäuseboden zur Anwendung kommt, kennzeichnet sich eine bevorzugte Variante der Erfindung dadurch, daß die Trägerplatte aus dem HF-Leiterbahnträger und einem Körper aus einem Material mit guter Wärmeleitfähigkeit, insbesondere Metall aufgebaut ist, wobei der HF-Leiterbahnträger oberhalb des Körpers angeordnet ist. Da der HF-Leiterbahnträger in diesem Fall nicht zur Wärmeableitung beiträgt sondern diese eher behindert, kann er vorzugsweise sehr dünn, beispielsweise als Folie ausgelegt sein.

Eine erstes Ausführungsbeispiel der erfindungsgemäßen Gehäuseanordnung kennzeichnet sich dadurch, daß ein optisches Element im Strahlengang des Laserlichtbündels hinter dem Modulgehäuse angeordnet ist, und daß der optische Lichtleiter in mechanisch stabiler Lage an dem optischen Element festlegbar ist. Bei diesem Ausführungsbeispiel wird die bereits erwähnte erfindungsgemäß geschaffene Möglichkeit der Auslagerung von optischen Elementen aus dem hermetisch dichten Modulgehäuse genutzt, indem die Ankopplung des optischen Lichtleiters unmittelbar an diesem ausgelagerten optischen Element erfolgt.

Bei dem ausgelagerten optischen Element kann es sich beispielsweise um ein Umlenkprisma oder einen optischen Isolator handeln.

Eine vorteilhafte Ausführungsvariante dieser Lösung kennzeichnet sich dadurch, daß die Gehäuseanordnung von einer durch Einschäumen und/oder Umspritzen mit einem schlecht wärmeleitenden Kunststoff bewirkten Schutzummantelung umgeben ist. Dadurch können Umwelteinflüsse von dem Modulgehäuse ferngehalten werden. Wenn ein Kühlelement, beispielsweise ein Peltier-Kühler vorgesehen ist, wird ferner in vorteilhafter Weise eine Wärmeisolation desselben erzielt.

Es kann ferner vorgesehen sein, daß die Gehäuseanordnung von einem Schutzgehäuse aus Kunststoff umgeben ist. Dieses Schutzgehäuse kann ein einfaches Kunststoffgehäuse sein, dessen Aufgabe darin besteht, die Gehäuseanordnung und insbesondere das ausgelagerte optische Element gegenüber Staub zu schützen und einen Wärmeaustausch über Konvektion zu unterbinden.

Ein zweites bevorzugtes Ausführungsbeispiel der Erfindung kennzeichnet sich dadurch, daß ein äußeres Gehäuse im Strahlengang des Laserlichtbündels hinter dem Modulgehäuse angeordnet ist und daß der optische Lichtleiter in mechanisch stabiler Lage an dem äußeren Gehäuse festlegbar ist. Da das äußere Gehäuse nicht hermetisch dicht sein muß, kann es aus kostengünstigen Materialien wie beispielsweise Kunstoff und Metall aufgebaut sein, wobei teure hermetisch dichte Leitungsdurchführungen und hermetisch dichte Fenster entfallen können. Für die in dem äußeren Gehäuse außerhalb des hermetisch dichten Modulgehäuses angeordneten optischen Bauteile können wiederum kostengünstige kunstoff- oder epoxidharzhaltige Ausführungen gewählt werden.

Nach einer zweckmäßigen Ausführungsvariante kann die Kappe des Modulgehäuses integral ausgebildet sein und aus einem laserlichtdurchlässigen Material, beispielsweise Glas oder bei ausreichend langwelliger Laserstrahlung auch Silizium bestehen. Es ist aber auch möglich, die Kappe aus einem die Umfangswände bildenden Rohrstück und einer das Rohrstück endseitig verschließenden Deckenplatte aufzubauen. Bei einem Lasermodul, dessen Strahlengang parallel zu der Trägerplatte verläuft, kann das Rohrstück aus einem laserlichtdurchlässigen Material, beispielsweise Glas oder Silizium bestehen. Demgegenüber muß bei einem senkrecht zu der Trägerplatte abstrahlenden Lasermodul das Laserlicht durch die Deckenplatte hindurchtreten können. Diese besteht dann vorzugsweise aus Glas oder Silizium, während das die Umfangswände des Modulgehäuses bildende Rohrstück aus Keramik oder Metall gebildet sein kann.

Vorzugsweise ist die Trägerplatte an ein außerhalb des Modulgehäuses angeordnetes Kühlelement, insbesondere ein Peltier-Element angekoppelt, wodurch wellenlängenstabile Module erzielt werden.

Weitere bevorzugte Ausführungsbeispiele und Ausgestaltungen der Erfindung sind in den Unteransprüchen angegeben.

Die Erfindung wird nachfolgend in beispielhafter Weise unter Bezugnahme auf die Zeichnung näher erläutert; in der Zeichnung zeigt:
- Fig. 1: eine Teilschnittdarstellung eines Gehäuses für gekühlte Lasermodule nach dem Stand der Technik;
- Fig.2: eine schematische Querschnittansicht eines Lasermoduls nach dem Stand der Technik;
- Fig. 3a: eine schematische Schnittansicht eines ersten Ausführungsbeispiels mit Faserankopplung an einem äußeren Gehäuse nach der Erfindung;
- Fig. 3b: das in Fig. 3a gezeigte erste Ausführungsbeispiel in Draufsicht;
- Fig. 4a: eine schematische Schnittdarstellung eines Modulgehäuses mit gehäuseinterner zweifacher Strahlumlenkung und integriertem optischen Isolator;
- Fig. 4b: eine schematische Darstellung des in Fig. 4a gezeigten Modulgehäuses in Draufsicht;
- Fig. 5: eine schematische Schnittdarstellung einer Variante eines Modulgehäuses mit gehäuseinterner einfacher Strahlumlenkung und externer zweiter Strahlumlenkung;
- Fig. 6: eine schematische Schnittdarstellung einer weiteren Variante eines Modulgehäuses mit gehäuseinterner erster Strahlumlenkung und externer zweiter Strahlumlenkung sowie externem optischen Isolator;
- Fig. 7: eine schematische Schnittdarstellungen einer dritten Variante eines Modulgehäuses mit gehäuseinterner erster Strahlumlenkung und externer zweiter Strahlumlenkung sowie externem optischen Isolator;
- Fig. 8a: eine schematische Schnittdarstellung einer vierten Variante eines Modulgehäuses mit gehäuseinterner erster Strahlumlenkung und einer weiteren Möglichkeit einer externen zweiten Strahlumlenkung;
- Fig. 8b: eine schematische Darstellung des in Fig. 8a gezeigten Modulgehäuses in Draufsicht;
- Fig. 9: eine schematische Darstellung einer Trägerplatte mit darauf angeordneten elektrischen Bauteilen und Leitungswegen in Draufsicht;
- Fig. 10: eine schematische Schnittansicht eines zweiten Ausführungsbeispiels der Erfindung mit Faserankopplung an einem äußeren Gehäuse;
- Fig. 11a: eine schematische Darstellung eines dritten Ausführungsbeispiels mit Faserankopplung an einem optischen Isolator;
- Fig. 11b: eine schematische Darstellung des in Fig. 11a gezeigten Ausführungsbeispiels in Draufsicht;
- Fig. 12: eine schematische Darstellung einer Variante des in den Fig. 11a, b gezeigten Ausführungsbeispiels mit Schutzgehäuse; und
- Fig. 13: eine schematische Darstellung eines weiteren in der erfindungsgemäßen Gehäuseanordnung einsetzbaren TO-Modulgehäuses.

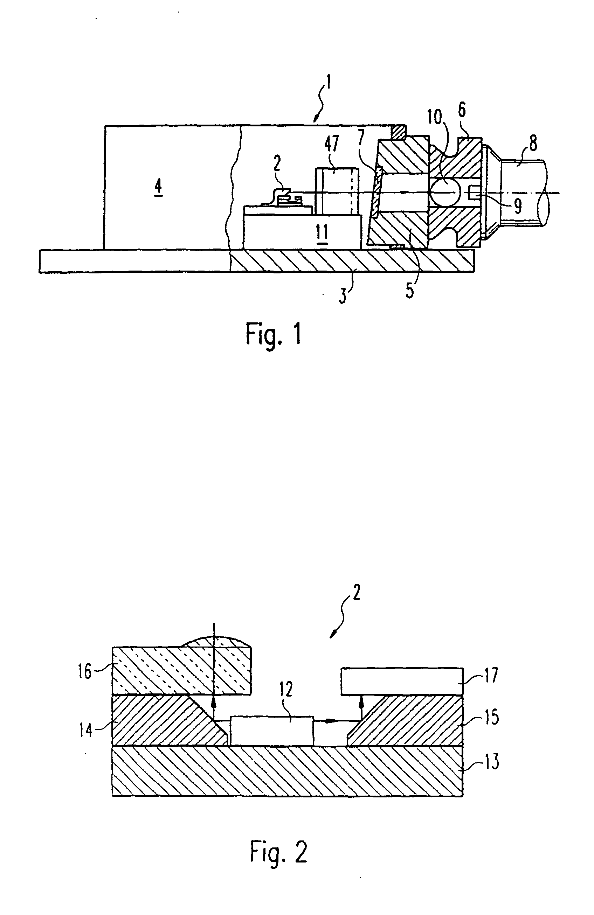

Nach Figur 1 besteht ein bekanntes Gehäuse 1 für ein Lasermodul (Lasersubmount) 2 aus einer metallischen Grundplatte 3, einem Gehäusedeckel 4 sowie einem Gehäuseflansch 5, der an einer Stirnseite des Gehäusedeckels 4 abdichtend in diesen eingesetzt ist. Der Gehäuseflansch 5 ist mit einer Durchtrittsbohrung versehen und weist an seiner gehäuseinnenseitigen Stirnfläche ein Gehäusefenster 7 auf. An der gehäuseaußenseitigen Stirnfläche ist der Gehäuseflansch 5 mit einem Faserflansch 6 gekoppelt, der von einer koaxialen Zentralbohrung durchlaufen wird. Der Faserflansch 6 fixiert eine optische Anschlußfaser 9 mit Schutz- und Zugentlastungsumhüllung 8. In der Zentralbohrung des Faserflansches 6 befindet sich eine Linse 10 zur definierten Einkopplung der von dem Lasermodul 2 abgegebenen Laserstrahlung in die Glasfaser 9.

Das Lasermodul 2 ist auf einem Peltier-Kühlelement 11 montiert, das seinerseits auf der metallischen Grundplatte 3 des Gehäuses 1 aufsteht. Neben dem Lasermodul 2 trägt das Peltier-Element 11 einen optischen Isolator 47, der dazu dient, durch Reflexion verursachte Rückwirkungen auf den Laser zu vermeiden.

Fig. 2 stellt den Grundaufbau des in Fig. 1 verwendeten Lasermoduls 2 dar. Als Lichtsender verwendet das Lasermodul 2 einen Laserchip 12, der auf einem aus Silizium bestehenden Träger 13 angeordnet ist. Der Träger 13, der auch als Si-Submount bezeichnet wird, trägt ferner zwei Umlenkprismen 14, 15, die zu beiden Seiten des Laserchips 12 angeordnet sind und Spiegelflächen aufweisen, die unter einem Winkel von 45° gegenüber der aktiven Fläche des Laserchips 12 orientiert sind. Auf dem einen Umlenkprisma 14 ist eine Koppellinse 16 aufgebracht und so angeordnet, daß die im Laserchip 12 erzeugte und von dem Umlenkprisma 14 umgelenkte Laserstrahlung die Koppellinse 16 im wesentlichen in Richtung ihrer optischen Achse durchläuft.

Auf dem zweiten Umlenkprisma 15 ist ein Monitor-Chip 17 derart angeordnet und befestigt, daß von diesem ein Teil der vom Laserchip 12 erzeugten optischen Strahlung empfangen wird. Der Monitor-Chip 17 kann zur Messung bzw. Regelung der Laserleistung verwendet werden. Hierbei kann das Umlenkprisma 15 auch ganz entfallen und der Monitor-Chip 17 kann direkt auf dem Si-Submount montiert sein.

Mit dem in den Fig. 1 und 2 dargestellten gekühlten Laserbauelement lassen sich Datenraten über 2,5 Gbit/s erzielen.

Nachteilig sind jedoch die aufgrund der aufwendigen Gehäusegestaltung hohen Herstellungskosten.

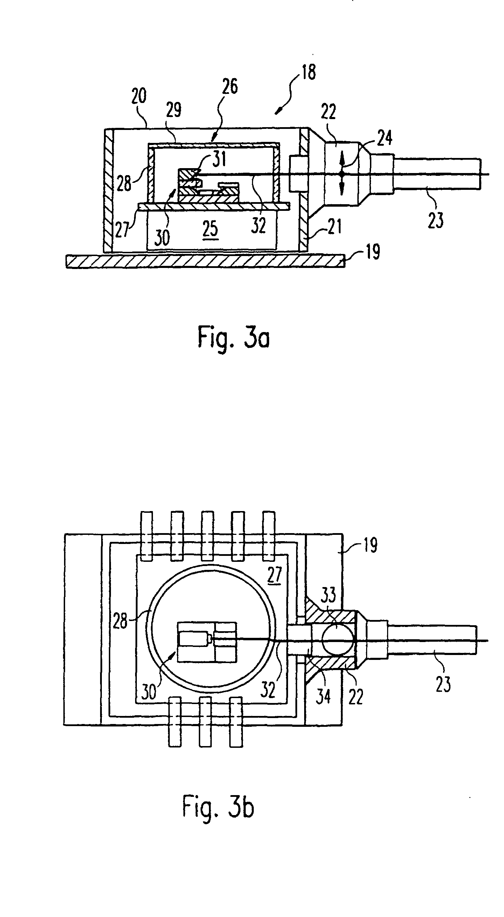

Fig. 3a zeigt ein erstes Ausführungsbeispiel nach der Erfindung. Ein äußeres Gehäuse 18 weist eine Bodenplatte 19 sowie einen auf der Bodenplatte 19 angeordneten Gehäusedeckel 20 auf. An einer Stirnseite 21 des Gehäusedeckels 20 ist ein Faserflansch 22 angeschlossen, der eine Glasfaser 23 in mechanisch stabiler Lage an dem äußeren Gehäuse 18 festlegt. Der Faserflansch 22 ist gegenüber dem äußeren Gehäuse 18 in Richtung des Doppelpfeils 24 justierbar.

Innerhalb des äußeren Gehäuses 18 befindet sich ein Peltier-Kühlelement 25 sowie ein darauf montiertes erfindungsgemäßes Modulgehäuse 26. Das Modulgehäuse 26 besteht aus einer gut wärmeleitenden Trägerplatte 27 sowie einem kappenförmigen Gehäusedeckel, der aus einem die Umfangswände bildenden, laserlichtdurchlässigen Rohrstück 28 sowie einer das Rohrstück 28 abschließenden Deckenplatte 29 aufgebaut ist. Innerhalb des Modulgehäuses 26 ist ein Lasermodul 30 angeordnet, dessen Grundaufbau im wesentlichen dem in Fig. 2 dargestellten Lasermodul 2 entspricht, sich von diesem jedoch durch das Vorhandensein eines weiteren Umlenkprismas 31 unterscheidet, das unmittelbar auf der Koppellinse 16 (Fig. 2) angebracht ist. Das Umlenkprisma 31 lenkt das durch die Linse 16 hindurchgelaufene Strahlenbündel um 90° um, so daß das Laserbündel 32 in Strahlrichtung hinter dem Umlenkprisma 31 im wesentlichen parallel zu dem Träger 13 (Lasersubmount) verläuft und in die am äußeren Gehäuse 18 ausgerichtete Glasfaser 23 einkoppelt.

Bei der dargestellten Aufbauweise erfolgt die Faserankopplung nicht an dem Modulgehäuse 26. Somit ist dieses keinen besonderen mechanischen Belastungen ausgesetzt. Aus diesem Grund kann das Modulgehäuse 26 auch bei Forderung nach hermetischer Dichtigkeit sehr einfach und kostengünstig ausgeführt sein. Beispielsweise kann das Rohrstück 28 aus Glas oder einem geeigneten Halbleitermaterial - für langwellige Lasermodule beispielsweise Silizium - gebildet sein. Die Deckenplatte 29 kann aus dem gleichen Material wie das Rohrstück bestehen und integral mit diesem gebildet sein. Es ist jedoch auch möglich, eine Deckenplatte aus Keramik oder Metall vorzusehen.

Ein weiterer Vorteil des in Fig. 3a gezeigten Aufbaus besteht darin, daß aufgrund der vollflächigen Anlage der Trägerplatte 27 an dem Peltier-Kühlelement 25 ein guter Wärmekontakt ermöglicht wird. Die Trägerplatte 27 kann aus einem Dielektrikum mit guter Wärmeleitfähigkeit wie beispielsweise AL₂O₃, AlN, BeO oder hochohmigem Si bestehen, oder es kann in alternativer Weise eine Trägerplatte 27 mit einer oberflächenseitig ausgebildeten Metallkaschierung aus Cu/W, Cu oder Kovar eingesetzt werden, die eine noch bessere wärmemäßige Anbindung des Lasermoduls 30 an das Peltier-Kühlelement 25 ermöglicht.

Fig. 3b zeigt den in Fig. 3a dargestellten Aufbau in Draufsicht. Zur Einkopplung des Laserbündels 32 in die Glasfaser 23 ist in einer Bohrung des Faserflansches 22 eine Linse 33 vorgesehen. In Strahlrichtung vor der Linse 33 ist ein optischer Isolator 34 angeordnet, der in den Faserflansch 22 hybrid integriert ist, und dessen Aufgabe es ist, reflektiertes Licht von dem Laserchip 12 fernzuhalten und somit durch Lichtreflektionen verursachte Rückwirkungen auf den Laserchip 12 wesentlich zu reduzieren. Derartige Faserflanschkomponenten mit oder ohne integrierter Linse 33 und optischem Isolator 34 sind als komplett gefertigte und getestete Ankoppeleinheiten beziehbar. Durch ihren Einsatz in Verbindung mit der Verwendung des erfindungsgemäßen Modulgehäuses lassen sich Ausbeuteprobleme bei der Endmontage verringern. Da ferner der optische Isolator 34 außerhalb des Modulgehäuses 26 angeordnet ist, können kostengünstige nicht Epoxidharz-freie Isolatorausführungen gewählt werden.

Das Lasermodul 30 ist in dem Modulgehäuse 26 dezentral angeordnet. Dadurch wird erreicht, daß das Laserbündel 32 etwas schräg durch das optisch durchlässige Rohrstück 28 hindurchtritt und somit an diesem reflektiertes Licht nicht auf den Laserchip 12 zurückgeworfen wird. Ferner kann das laserlichtdurchlässige Rohrstück 28 entspiegelt sein.

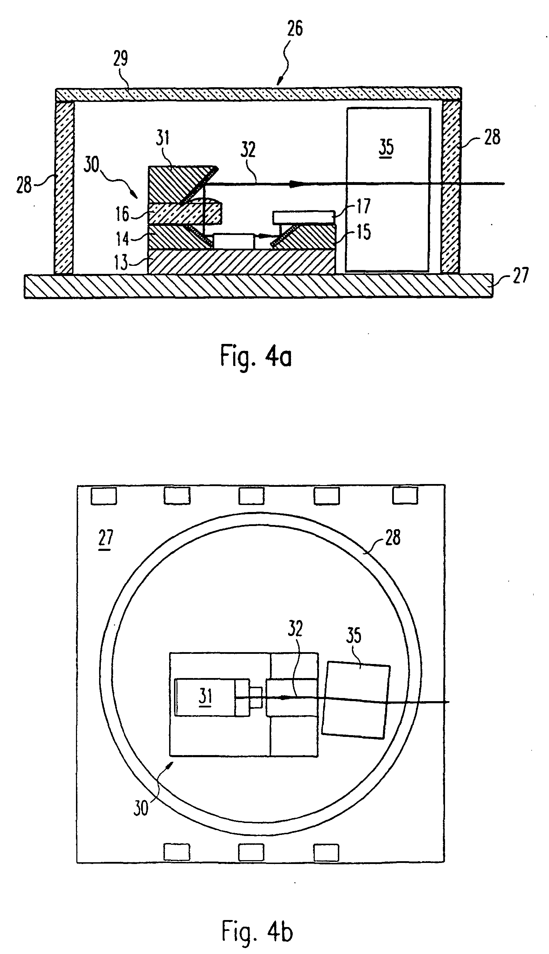

Fig. 4a zeigt eine schematische Schnittdarstellung eines weiteren Modulgehäuses 26. Dabei sind gleich Teile wie in den vorhergehenden Figuren mit denselben Bezugszeichen gekennzeichnet. Der in Fig. 4a gezeigte Aufbau des Modulgehäuses 26 unterscheidet sich von der Ausführung nach Fig. 3a nur dadurch, daß der optische Isolator 35 nunmehr in dem Modulgehäuse 26 angeordnet ist. Dies hat den Vorteil, daß auch an dem lichtdurchlässigen Rohrstück 28 auftretende Lichtreflexionen durch den optischen Isolator 35 von dem Laserchip 12 ferngehalten werden können. Ferner wird aufgrund der trägerplattenseitigen Anbringung ein besonders guter Wärmekontakt des optischen Isolators 35 mit dem Peltier-Kühlelement 25 geschaffen. Dies ist von Vorteil, da der innerhalb enger Temperaturbereiche optimierbare optische Isolator 35 auf diese Weise sehr temperaturstabil betrieben werden kann.

Nach Fig. 4b ist das Lasermodul 30 wiederum dezentral in der zylinderförmigen Modulgehäusekappe angeordnet. Die Symmetrieachse des optische Isolators 35 ist gegenüber der Strahlrichtung des Laserbündels 32 leicht verkippt.

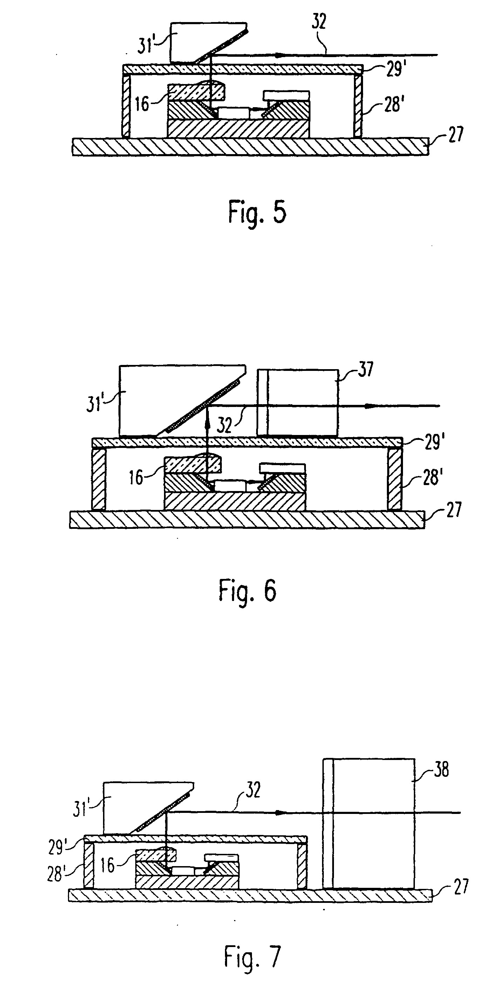

Die Fig. 5, 6 und 7 zeigen weitere Beispiele für die Anordnung optischer Elemente an dem erfindungsgemäßen Modulgehäuse 26. Die in diesen Figuren gezeigten Anordnungen haben gemeinsam, daß der durch die Koppellinse 16 hindurchtretende Laserstrahl das Modulgehäuse 26 durch dessen laserlichtdurchlässige Deckenplatte 29' verläßt und nachfolgend von einem auf der Deckenplatte 29' angebrachten zweiten Umlenkprisma 31' um 90° in Horizontalrichtung umgelenkt wird. Die Deckenplatte 29' kann aus Glas oder einem geeigneten, für das Laserlicht transparenten Halbleitermaterial sein. Um Rückwirkungen auf den Laser zu vermeiden ist die Deckenplatte 29' entspiegelt und der Laserstrahl wird leicht schräg unter einem Winkel von beispielsweise 5° bis 8° zur Normalen der Dekkenplatte 29' durch diese hindurchgeschickt. Letzteres kann entweder durch eine Schrägstellung der Deckelplatte 29' oder einfacher durch eine Strahlverkippung des Lasermoduls durch entsprechende Justage der Koppellinse 16 erreicht werden.

In den Fig. 5, 6 und 7 kann das Rohrstück 28' auch aus einem Laserlicht-undurchsichtigen Material, beispielsweise Metall oder Keramik oder dergleichen bestehen. Eine hermetisch dichte Verbindung des Rohrstücks 28' mit der Trägerplatte 27 kann beispielsweise durch Schweißen, Löten oder Anglasen hergestellt werden. Sämtliche in den Fig. 5 bis 7 gezeigten Anordnungen können bei dem ersten Ausführungsbeispiel nach den Fig. 3a, 3b zur Anwendung kommen.

In Figur 6 ist ein optischer Isolator 37 in unmittelbarer Nähe zu dem zweiten Umlenkprisma 31' auf der Deckenplatte 29' angeordnet. Alternativ dazu kann nach Fig. 7 ein optischer Isolator 38 auch auf der Trägerplatte 27 angebracht sein. Aufgrund des guten Wärmekontakts mit der Trägerplatte 27 sowie der temperaturempfindlichen Optimierbarkeit des optischen Isolators 38 ist diese Anordnung besonders dann von Vorteil, wenn eine Kühlung des Lasermoduls vorgesehen ist.

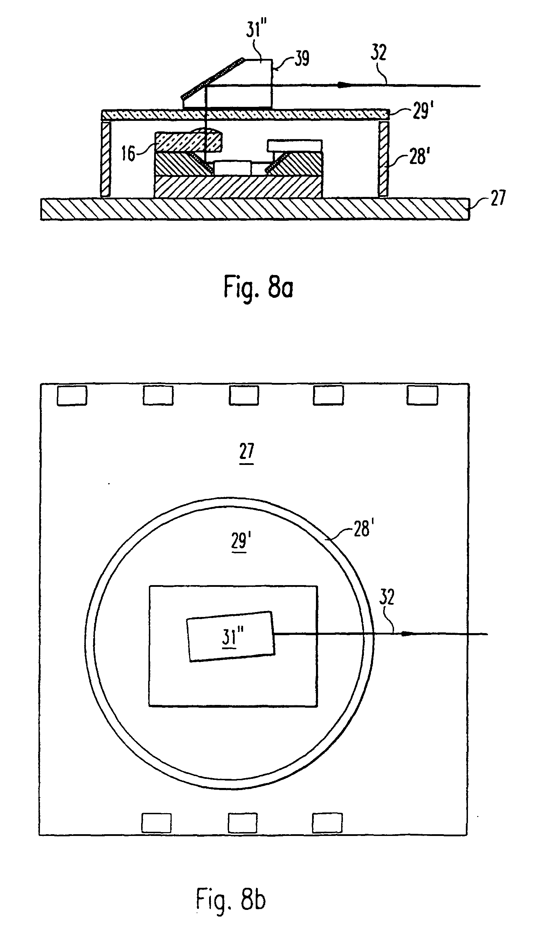

Die Fig. 8a und 8b zeigen ein weiteres Beispiel für ein Lasermodulgehäuse 26 mit deckenseitigem Strahlaustritt. Im Vergleich zu dem in den vorhergehenden Figuren dargestellten Beispielen unterscheidet sich diese Ausführung lediglich durch die Form der Strahlumlenkung in dem zweiten Umlenkprisma 31''. Bei der hier dargestellten Variante ist es zweckmäßig, die Austrittsfläche 39 des Umlenkprismas 31'' zu entspiegeln und ferner für einen bezüglich dieser Fläche geneigten Strahlaustritt zu sorgen, wie dies in Fig. 8b gezeigt ist. Erreicht wird dies, indem die Symmetrieachse des zweiten Umlenkprismas 31" leicht gegenüber der Strahlrichtung des Laserbündels 32 verdreht ist.

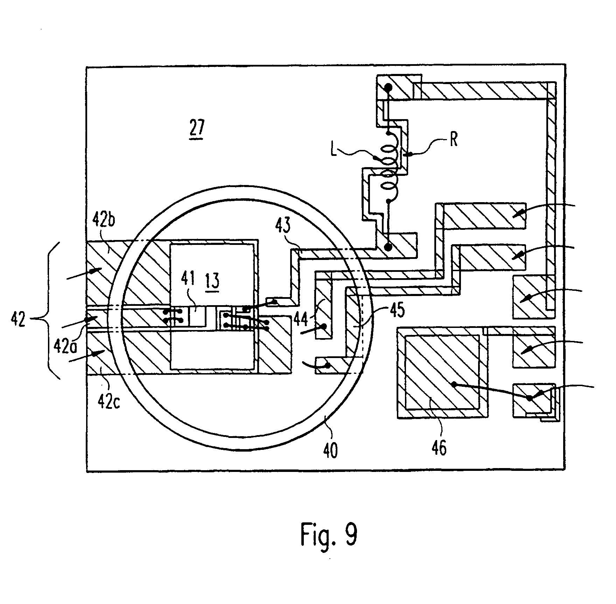

Fig. 9 zeigt eine Trägerplatte 27 in Draufsicht, wobei die in den bisherigen Figuren nicht dargestellten Leitungswege, Kontaktpads und elektrischen Bauteile erkennbar sind. Zur hermetisch dichten Anbringung der hier nicht dargestellten Kappe ist auf der Trägerplatte 27 ein umlaufender Dichtring 40 aufgebracht, der beispielsweise aus Metall besteht und sowohl eine dichte Verbindung mit der Trägerplatte 27 ausbildet als auch eine hermetisch dichte Verbindung mit der aufzubringenden Kappe, beispielsweise durch Löten, Schweißen oder ein ähnliches Verfahren ermöglicht. Im Innenbereich des Dichtrings 40 befindet sich der Träger 13 eines Lasermoduls, welcher ebenfalls durch Kleben, Löten oder Schweißen auf der Trägerplatte 27 befestigt sein kann. Der Träger 13 ist an seiner Oberfläche mit einem Leiterbahnmuster versehen, das den hier nicht dargestellten Laserchip elektrisch kontaktiert und seinerseits von äußeren Zuleitungen kontaktiert wird. Ein HF-Datensignal wird über eine Koplanarleitung 42 zugeleitet, die einen zentralen Leiterstreifen 42a für das HF-Datensignal und zwei auf Masse liegende benachbarte Leiterstreifen 42b und 42c aufweist. Die Leiterbahnstreifen 42a, 42b, 42c sind auf einer aus einem dielektrischen Material bestehenden Leiterbahnträgerschicht der Trägerplatte 27 aufgebracht. An der gegenüberliegenden Seite wird das Leiterbahnmuster über drei Zuleitungen 43, 44 und 45 elektrisch kontaktiert, die in der angegebenen Reihenfolge den Laserchip über eine HF-Drossel L und einen parallelen Schichtwiderstand R mit einem Vorstrom (bias-Strom) versorgen sowie die elektrische Verbindung zu dem Monitor-Chip 17 herstellen. Ferner ist auf der Trägerplatte 27 ein als NTC-Widerstand ausgeführter Temperatursensor 46 mit den entsprechenden elektrischen Zuleitungen und Kontaktpads ausgebildet.

Um bei Verwendung eines metallischen Dichtrings 40 die hermetische Dichtigkeit zwischen dem Dichtring 40 und der Trägerplatte 27 nicht zu beeinträchtigen und andererseits die Möglichkeit eines elektrischen Kurzschlusses mit dem Dichtring 40 auszuschließen, sind die Leiterbahnen 42, 43, 44 und 45 unterhalb des Dichtrings 40 und mit einer dielektrischen Isolierschicht von diesem getrennt durchgeführt.

In dem gezeigten Beispiel liegt der Temperatursensor 46 sowie der integrierte Schichtwiderstand R und die HF-Drossel L außerhalb des Dichtrings 40 und können daher ohne weiteres mit Flußmittel gelötet oder mit Gießharz vergossen werden. Es ist jedoch auch möglich, einen weiter außenliegenden Verlauf des Dichtrings 40 vorzusehen, bei dem beispielsweise nur die äußeren Anschlußpads außerhalb des Dichtrings 40 und somit außerhalb des erfindungsgemäßen Modulgehäuses 26 liegen.

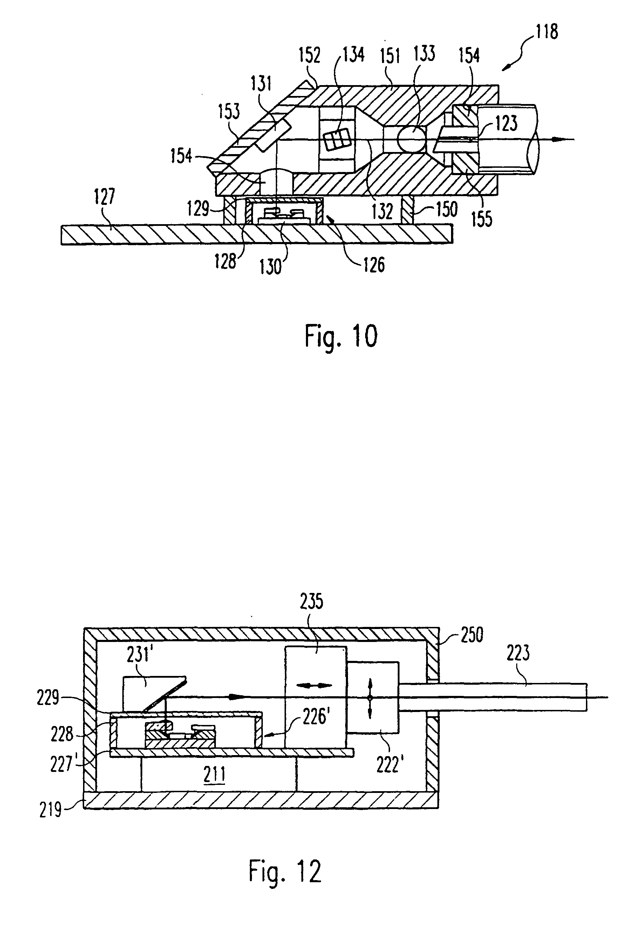

Fig. 10 zeigt ein zweites Ausführungsbeispiel nach dem ersten Gesichtspunkt der vorliegenden Erfindung. Auf einer metallischen Trägerplatte 127 mit einem oberflächenseitig verlaufenden dielektrischen HF-Leiterbahnträger ist ein Lasermodul 130 angeordnet, das in einem Lasermodulgehäuse 126 aufgenommen ist, dessen Kappe von einem Rohrstück 128 sowie einer transparenten Deckenplatte 129 gebildet ist. Der Aufbau des Lasermodulgehäuses 126 entspricht einem der zuvor beschriebenen Lasermodulgehäusen 26 mit deckenseitigem Strahlaustritt. Oberhalb des Lasermodulgehäuses 126 ist ein äußeres Gehäuse 118 angeordnet, das von einem auf der Trägerplatte 127 aufsitzenden Abstandsring 150 getragen und mittels dieses in seiner Lage relativ zum Lasermodulgehäuse 126 festgelegt wird. Das äußere Gehäuse 118 weist einen rohrstutzenartig ausgebildeten Gehäusekörper 151 aus Metall auf. Das eine Ende des Gehäusekörpers 151 ist als Schrägflächenbereich 152 ausgebildet, an dem eine Abschlußplatte 153 mit einem Umlenkspiegel 131 angebracht ist. Ein das Lasermodulgehäuse dekkenseitig verlassendes Laserbündel tritt durch eine Öffnung 154 in den Gehäusekörper 151 ein und wird von dem Umlenkspiegel 131 kolinear zu der Gehäuseachse umgelenkt. Im Inneren des Gehäusekörpers 151 befindet sich ein optischer Isolator 134 sowie eine Linse 133. An seinem dem Schrägflächenbereich 152 entgegengesetzten Ende weist der Gehäusekörper eine Anschlußbohrung 154 auf, in die ein Steckerteil 155 eines optischen Wellenleiterkabels mit zentraler Glasfaser 123 paßgenau und lagedefiniert einsetzbar ist. Die Glasfaser 123 ist an ihrem freien Ende vorzugsweise mit einem Schrägschliff versehen.

Die Wirkungsweise dieser zweiten Ausführungsform ist wie folgt:

Die in dem Lasermodul 130 angeordnete Koppellinse 16 (Fig. 2) erzeugt ein stark vergrößertes Zwischenbild, das typischerweise den 4- bis 5-fachen Feckdurchmesser der Monomode-Glasfaser 123 aufweist. Dies hat zur Folge, daß der Abstand zwischen der Koppellinse 16 und der Linse 133 unkritisch ist. Die Linse 133 verkleinert dieses Zwischenbild dann auf die Fleckgröße der anzukoppelnden Glasfaser 123, wodurch ein hoher Koppelwirkungsgrad erzielt wird. Diese Aufbauweise ermöglicht es, vorgefertigte und geprüfte äußere Gehäuse 118 bestehend aus Gehäusekörper 151, Umlenkspiegel 131, gegebenenfalls optischen Isolator 134 sowie Linse 133 einzusetzen und diese äußeren Gehäuse 118 nachfolgend in der dargestellten Weise mit einem ebenfalls separat gefertigten und kontrollierten erfindungsgemäßen Lasermodulgehäuse 126 zu koppeln. Zur Optimierung der Lichtauskopplung müssen die beiden Gehäuse 118, 126 relativ zueinander lagemäßig justiert und fixiert werden. Die Fixierung kann durch Laserschweißen am Abstandsring 150 erfolgen.

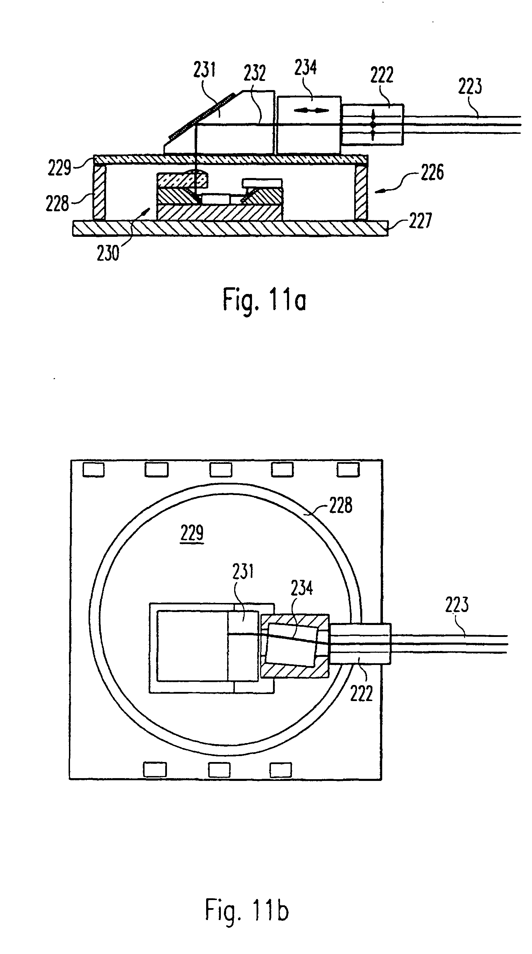

Fig. 11a und 11b zeigen ein drittes Ausführungsbeispiel der Erfindung, bei dem anders als in den bisher beschriebenen Ausführungsbeispielen die Faserankopplung nicht an einem äußeren Gehäuse sondern an einem optischen Bauelement erfolgt. Ein Lasermodul 230 ist in einem Lasermodulgehäuse 226 aufgenommen, welches in der gleichen Weise wie in den Fig. 8a und 8b dargestellt aus einer Trägerplatte 227, einem Rohrstück 228 und einer Deckenplatte 229 aufgebaut ist. In ebenfalls analoger Weise zu den Fig. 8a und 8b ist ein Umlenkprisma 231 auf der Deckenplatte 229 angebracht, das das von dem Lasermodul 230 emittierte Laserlicht in ein parallel zu der Ebene der Trägerplatte 227 verlaufendes Laserbündel 232 umlenkt. In Strahlrichtung unmittelbar hinter dem Umlenkprisma 231 befindet sich ein ebenfalls auf der Deckenplatte 229 angebrachter optischer Isolator 234, der zu Justagezwecken in strahlparalleler Richtung verschieblich ist. Die Lichtaustrittsfläche des optischen Isolators 234 ist - beispielsweise durch eine Klebung - fest mit einem Faserflansch 222 einer Glasfaser 223 verbunden. Der optische Isolator 234 wird in Richtung der Faserachse und der Faserflansch 222 quer zur Faserachse bezüglich dem optischen Isolator 234 justiert. Wenn kein optischer Isolator 234 vorgesehen ist (beispielsweise bei Modulen mit einer etwas geringeren Datenrate) kann der Faserflansch 222 auch direkt am Umlenkprisma 231 fixiert sein.

Fig. 11b zeigt die in Fig. 11a dargestellte Anordnung in Draufsicht und verdeutlicht den Strahlversatz in dem optischen Isolator 234.

Dieses Ausführungsbeispiel weist in bezug auf seine Eignung für hermetische Dichtigkeit und für eine Ankopplung eines Kühlelements die gleichen Vorzüge wie die ersten beiden Ausführungsbeispiele auf.

Insbesondere bei dem Einsatz eines Kühlelements in der bereits erläuterten Weise kann es zweckmäßig sein, die gesamte Einheit durch Umschäumen oder Umspritzen mit einem schlecht wärmeleitenden Kunststoff gegenüber Umwelteinflüssen und Wärmeaustausch zu schützen, wobei auf diese Weise auch eine Zugentlastung der Glasfaser erreichbar ist.

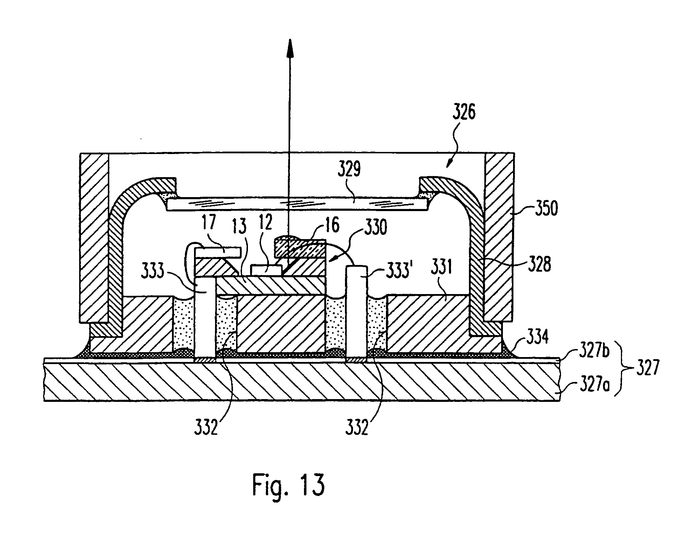

Fig. 12 zeigt eine Variante des in den Fig. 11a, 11b dargestellten dritten Ausführungsbeispiels, wobei gleiche Teile mit den selben Bezugszeichen gekennzeichnet sind. Auch hier erfolgt die Ankopplung eines Faserflansches 222' direkt an einem optischen Isolator 235. Im Unterschied zu dem dritten Ausführungsbeispiel ist der optische Isolator 235 hier jedoch an der mit einem Peltier-Kühlelement 221 in Kontakt stehenden Trägerplatte 227' angebracht, wodurch eine gute Temperaturstabilisierung des optischen Isolators 235 bewirkt wird. Ferner ist ein frontseitig verspiegeltes Umlenkprisma 231' gewählt.

Ein Peltier-Kühlelement 211 ist auf einer Bodenplatte 219 montiert, auf die eine einfache Schutzhaube 250 aus einem Kunststoffmaterial aufgesetzt ist, welche den Gesamtaufbau umgibt. Die Schutzhaube 250 schützt die außerhalb des Modulgehäuses 226' angeordneten optischen Komponenten vor Staub und verhindert einen Wärmeaustausch durch Konvektion.

Sämtliche dargestellten Ausführungsbeispiele sind in ihrer Funktionalität vergleichbar und zeichnen sich stets durch das Prinzip der Verwendung des erfindungsgemäßen Modulgehäuses als laseroptische Kerneinheit aus. Durch dieses Aufbauprinzip wird ein hohes Maß an Gestaltungsvariabilität und Modularität erreicht, wodurch sich besonders für hermetisch dichte und/oder gekühlte Bauelemente kostengünstige Realisierungen ergeben.

Fig. 13 zeigt ein weiteres Beispiel eines Modulgehäuses 326 mit innerhalb des Gehäuses angeordnetem Lasermodul 330. Das Lasermodul 330 entspricht dem in Fig. 2 dargestellten bekannten Lasermodul. Das Modulgehäuse 326 weist eine Kappe bestehend aus einer Umfangswand 328 und einem deckenseitig hermetisch dicht angebrachten Fenster 329 auf, die der bei üblichen TO-Gehäusen verwendeten Kappe entspricht. Die Kappe ist von einem Abstandsring 350 umgeben, über den das Modulgehäuse 326 beispielsweise wie in Fig. 10 dargestellt mit einem äußeren Gehäuse koppelbar ist. Die Umfangswand 328 ist hermetisch dicht mit einem das Lasermodul 330 tragenden Gehäuseboden 331 verschweißt. Der Gehäuseboden 331 weist Kontaktjerungsbohrungen 332 auf, die von Kontaktierungsstiften 333, 333' durchsetzt sind. Während der Kontaktierungsstift 333' zur Durchführung des HF-Datensignals dient, ermöglicht der Kontaktierungsstift 333 sowie weitere nicht dargestellte Kontaktierungsstifte die elektrische Kontaktierung des Monitor-Chips 17, eines ggf. vorgesehenen Temperatursensors sowie die Zuleitung des Bias-Stroms für den Laserchip 13.

Unterhalb des Gehäusebodens 331 ist eine Trägerplatte 327 angeordnet und mittels eines Klebers 334 mit dieser verbunden. Die Trägerplatte 327 ist aus einem beispielsweise aus Metall bestehenden Körper 327a mit guter Wärmeleitfähigkeit sowie einem darüber verlaufenden HF-Leiterbahnträger 327b aufgebaut. Der HF-Leiterbahnträger 327b führt eine in Fig. 13 nicht erkennbare, als Mikrostreifenleitung oder Koplanarleitung ausgebildete HF-Leiterbahnstrecke unmittelbar zu dem Kontaktierungsstift 333'. Um eine gute HF-Tauglichkeit aufzuweisen, muß die freie, aus dem Gehäuseboden herausragende Länge des HF-Kontaktierungsstiftes 333' so klein wie nur möglich sein. Aus diesem Grund wird der für die Klebung benötigte Abstand zwischen Gehäuseboden 331 und Trägerplatte 327 minimal gehalten. Aufgrund dieser Maßnahmen weist auch dieses Modulgehäuse 326 die gewünschten guten HF-Eigenschaften und gleichzeitig die für eine Kühlung erforderliche effiziente thermische Ankopplung an die Trägerplatte auf.

Das Modulgehäuse 326 kann in gleicher Weise wie die in den Fig. 5 bis 8 und 10 bis 12 gezeigten Modulgehäuse 26, 126 und 226 in variabler Weise eingesetzt werden. Ein Vorteil des Modulgehäuses 326 besteht darin, daß die hermetische Dichtigkeit des Gehäuses in einfacher Weise durch eine Widerstandsschweißung zwischen dem Gehäuseboden 331 und der Umfangswand 328 erzielbar ist. Ferner ist vorteilhaft, daß auch bereits bestehende TO-Lasermodulgehäuse nach einer entsprechenden Kürzung ihrer Durchführungspins und Montage auf einer erfindungsgemäß aufgebauten Trägerplatte zum Einsatz kommen können.

## Patentansprüche

1. Gehäuseanordnung für ein Lasermodul
mit einem hermetisch dichten Modulgehäuse (26),
das zur Aufnahme des Lasermoduls (30) vorgesehen ist,
das mindestens einen laserlichtdurchlässigen Austrittswandabschnitt (28) aufweist und
das eine Trägerplatte (27) als Boden besitzt,
wobei die Trägerplatte einen aus einem dielektrischen Material bestehenden HF-Leiterbahnträger umfaßt, an dem eine HF-Leiterbahnstrecke zur elektrischen HF-Kontaktierung des Lasermoduls geführt ist, und
mit einer Einrichtung (22) zur Ankopplung eines Lichtleiters **(23)** ,
**dadurch gekennzeichnet, daß**
Umfangswände des Modulgehäuses durch ein laserlichtdurchlässiges Rohrstück (28) gebildet sind und
eine das Rohrstück abschließende Deckenplatte (29) aus Keramik oder Metall vorgesehen ist.

2. Gehäuseanordnung für ein Lasermodul
mit einem hermetisch dichten Modulgehäuse (126, 226, 226', 326),
das zur Aufnahme des Lasermoduls (130, 230, 330) vorgesehen ist,
das mindestens einen laserlichtdurchlässigen Austrittswandabschnitt (29', 129, 229, 329) aufweist und
das eine Trägerplatte (27, 127, 227, 227') als Boden besitzt,
wobei die Trägerplatte einen aus einem dielektrischen Material bestehenden HF-Leiterbahnträger umfaßt, an dem eine HF-Leiterbahnstrecke zur elektrischen HF-Kontaktierung des Lasermoduls geführt ist, und
mit einer Einrichtung (154, 222, 222') zur Ankopplung eines Lichtleiters (123, 223),
**dadurch gekennzeichnet, daß**
Umfangswände des Modulgehäuses durch ein Rohrstück (28', 128, 228) aus Keramik oder Metall gebildet sind und
eine das Rohrstück abschließende, laserlichtdurchlässige Dekkenplatte (29', 129, 229) vorgesehen ist.

3. Gehäuseanordnung nach Anspruch 1 oder 2,
**dadurch gekennzeichnet, daß** die den Boden des Modulgehäuses (26, 126, 226, 226') bildende Trägerplatte (27, 127, 227, 227') aus dem HF-Leiterbahnträger aus dem dielektrischen Material besteht.

4. Gehäuseanordnung nach Anspruch 1 oder 2,
**dadurch gekennzeichnet, daß** die den Hoden des Mödulgehäuses (26, 126, 226, 226') bildende Trägerplatte (27, 127, 227, 227') aus dem HF-Leiterbahnträger und einer über dem HF-Leiterbahnträger angeordneten Metallschicht besteht.

5. Gehäuseanordnung nach einem der Ansprüche 1 bis 4,
**dadurch gekennzeichnet, daß** der HF-Leiterbahnträger eine Mehrlagenplatine ist.

6. Gehäuseanordnung nach einem der Ansprüche 1 bis 5,
**dadurch gekennzeichnet,**
- **daß** ein optisches Element (231, 231'; 234, 234') im Strahlengang des Laserlichtbündels (232) hinter dem Modulgehäuse (226, 226', 326) angeordnet ist und
- **daß** der optische Lichtleiter (2.3; 123; 223) in mechanisch stabiler Lage an das optische Element (231, 231'; 234, 234') angekoppelt ist.

7. Gehäuseanordnung nach Anspruch 6, **dadurch gekennzeichnet,**
**daß** das optische Element ein Umlenkprisma (231, 231') ist.

8. Gehäuseanordnung nach Anspruch 6, **dadurch gekennzeichnet,**
**daß** das optische Element ein optischer Isolator (234, 234') ist.

9. Gehäuseanordnung nach einem der Ansprüche 1 bis 8,
**dadurch gekennzeichnet, daß** die Gehäuseanordnung von einer Schutzummantelung aus einem geschäumten oder gespritzten schlecht wärmeleitenden Kunststoff umgeben ist.

## Claims

1. Housing arrangement for a laser module with a hermetically sealed module housing (26), which is intended for receiving the laser module (30), which has at least one laser-light-transmitting emergent wall portion (28) and which has a carrier plate (27) as a base, the carrier plate comprising an HF conductor track carrier consisting of a dielectric material, on which a section of HF conductor track is led for the electrical HF contacting of the laser module, and with a device (22) for the coupling of a light guide (23), **characterized in that** circumferential walls of the module housing are formed by a laser-light-transmitting piece of pipe (28) and there is provided a top plate (29) of ceramic or metal terminating the piece of pipe.

2. Housing arrangement for a laser module with a hermetically sealed module housing (126, 226, 226', 326), which is intended for receiving the laser module (130, 230, 330), which has at least one laser-light-transmitting emergent wall portion (29', 129, 229, 329) and which has a carrier plate (27, 127, 227, 227') as a base, the carrier plate comprising an HF conductor track carrier consisting of a dielectric material, on which a section of HF conductor track is led for the electrical HF contacting of the laser module, and with a device (154, 222, 222') for the coupling of a light guide (123, 223), **characterized in that** circumferential walls of the module housing are formed by a piece of pipe (28', 128, 228) of ceramic or metal and there is provided a laser-light-transmitting top plate (29', 129, 229) terminating the piece of pipe.

3. Housing arrangement according to Claim 1 or 2, **characterized in that** the carrier plate (27, 127, 227, 227') forming the base of the module housing (26, 126, 226, 226') comprises the HF conductor track carrier consisting of the dielectric material.

4. Housing arrangement according to Claim 1 or 2, **characterized in that** the carrier plate (27, 127, 227, 227') forming the base of the module housing (26, 126, 226, 226') comprises the HF conductor track carrier and a metal layer arranged over the HF conductor track carrier.

5. Housing arrangement according to one of Claims 1 to 4, **characterized in that** the HF conductor track carrier is a multilayer printed circuit board.

6. Housing arrangement according to one of Claims 1 to 5, **characterized**
- **in that** an optical element (231, 231', 234, 234') is arranged behind the module housing (226, 226', 326) in the path of rays of the laser light beam (232), and
- **in that** the optical light guide (23; 123; 223) is coupled in a mechanically stable position to the optical element (231, 231'; 234, 234').

7. Housing arrangement according to Claim 6, **characterized in that** the optical element is a deviating prism (231, 231').

8. Housing arrangement according to Claim 6, **characterized in that** the optical element is an optical isolator (234, 234').

9. Housing arrangement according to one of Claims 1 to 8, **characterized in that** the housing arrangement is surrounded by a protective sheathing made of a foamed or injection-moulded plastic with poor heat conduction.

## Revendications

1. Ensemble boîtier pour un module laser
comprenant un boîtier (26) de module étanche hermétiquement, qui est prévu pour le logement du module laser (30),
qui a au moins une partie de paroi (28) de sortie transparente à la lumière laser et
qui a une plaque (27) support comme fond,
la plaque support comprenant un support de piste conductrice (HF) en un matériau diélectrique, sur lequel est guidé une section de piste conductrice (HF) pour la mise en contact électrique (HF) du module laser, et
comprenant un dispositif (22) de couplage d'une fibre optique (23),
**caractérisé en ce que**
des parois du pourtour du boîtier du module sont formées par un tronçon (28) tubulaire transparent à la lumière laser et
il est prévu une plaque (29) de couvercle en céramique ou en métal, qui ferme le tronçon tubulaire.

2. Ensemble boîtier pour un module laser
comprenant un boîtier (126, 226, 226', 326) de module étanche hermétiquement,
qui est prévu pour le logement du module laser (130 230, 330)
qui a au moins une partie de paroi (29', 129, 229, 329) de sortie qui est transparente à la lumière laser, et
qui a une plaque (27, 127, 227, 227') support comme fond, et
la plaque support comprenant un support de piste conductrice (HF) en un matériau diélectrique, sur lequel est guidé une section de piste conductrice (HF) pour la mise en contact électrique (HF) du module laser, et
comprenant un dispositif (154, 222, 222') de couplage d'une fibre optique (123, 223),
**caractérisé en ce que**
les parois du pourtour du boîtier du module sont formées par un tronçon (28', 128, 228) tubulaire en céramique ou en métal, et
il est prévu une plaque (29', 129, 229') de couvercle qui ferme le tronçon tubulaire et qui est transparente à la lumière laser.

3. Ensemble boîtier suivant la revendication 1 ou 2,
**caractérisé en ce que** les plaques (27, 127, 227, 227') support formant le fond du boîtier (26, 126, 226, 226') du module sont constituées du support de piste conductrice HF en le matériau diélectrique.

4. Ensemble boîtier suivant la revendication 1 ou 2,
**caractérisé en ce que** les plaques (27, 127, 227, 227') support formant le fond du boîtier (26, 126, 226, 226') du module sont constituées du support de piste conductrice HF et d'une couche métallique disposée sur le support de piste conductrice HF.

5. Ensemble boîtier suivant l'une des revendications 1 à 4,
**caractérisé en ce que** le support de piste conductrice HF est une platine à plusieurs couches.

6. Ensemble boîtier suivant l'une des revendications 1 à 5,
**caractérisé en ce que**
- un élément (231, 231', 234 234') optique est disposé dans le trajet des rayons du faisceau (232) de lumière laser derrière le boîtier (226, 226', 326) du module et
- la fibre (23, 123, 223) optique est couplée en une position stable mécaniquement à l'élément (231, 231', 234, 234') optique.

7. Ensemble boîtier suivant la revendication 6,
**caractérisé en ce que** l'élément optique est un prisme (231, 231') de renvoi.

8. Ensemble boîtier suivant la revendication 6,
**caractérisé en ce que** l'élément optique est un isolateur (234, 234') optique.

9. Ensemble boîtier suivant l'une des revendications 1 à 8,
**caractérisé en ce que** l'ensemble boîtier est entouré d'une enveloppe de protection en une matière plastique mousse ou obtenue par coextrusion, qui est mauvaise conductrice de la chaleur.
